Europäisches Patentamt

European Patent Office

Office européen des brevets

(19)

(11) Veröffentlichungsnummer : **0 053 581**
**B1**

(12) # EUROPÄISCHE PATENTSCHRIFT

(45) Veröffentlichungstag der Patentschrift :
21.01.87

(21) Anmeldenummer : 81810464.8

(22) Anmeldetag : 19.11.81

(51) Int. Cl.⁴ : **G 01 R 17/06**

(54) **Fehlerkompensierter Spannungswandler für Hochspannung.**

(30) Priorität : 28.11.80 AT 5830/80

(43) Veröffentlichungstag der Anmeldung :
09.06.82 Patentblatt 82/23

(45) Bekanntmachung des Hinweises auf die Patenterteilung : 21.01.87 Patentblatt 87/04

(84) Benannte Vertragsstaaten :
AT BE CH DE FR GB LI

(56) Entgegenhaltungen :
DE-B- 1 061 433
DE-B- 1 220 036
DE-C- 615 752
DE-C- 1 046 181
FR-A- 860 170
US-A- 3 419 788
US-A- 3 497 793
Bull. SEV 71 (1980), S. 450-455

(73) Patentinhaber : MOSER-GLASER & CO. AG
Transformatoren Hofackerstrasse 24
CH-4132 Muttenz (CH)

(72) Erfinder : Max, Friedrich
Germanenweg 3
CH-4132 Muttenz (CH)

EP 0 053 581 B1

Jouve, 18, rue St-Denis, 75001 Paris, France

## Beschreibung

Die vorliegende Erfindung betrifft einen Hochspannungswandler, bei welchem der durch die Bürde bedingte Fehler mittels eines Verstärkers im Sekundärstromkreis kompensiert wird, bei welchem ein in seiner Vektorrichtung durch eine Abgriffimpedanz bestimmter, vom Sekundärstrom erzeugter kleiner Spannungsabfall am Eingang des Verstärkers liegt und bei welchem die Ausgangsspannung dieses Verstärkers in Serie in den Sekundärkreis des Wandlers eingeschleift ist.

Ein unbelasteter Spannungswandler liefert an seinen Sekundäranschlüssen eine Spannung, welche dem sogenannten Leerlaufübersetzungsverhältnis entspricht. Wird die Sekundärwicklung des Wandlers belastet, dann ruft die Belastung im Wandler einen Spannungsabfall hervor, durch welchen die Sekundärspannung verändert, bzw. abgefälscht wird. Um die Abfälschung der Sekundärspannung in den gewünschten Grenzen zu halten, sind die Aktivteile des Wandlers, Wicklungen und Eisenkern, entsprechend zu dimensionieren. Dies ist besonders für Hochspannungswandler kostspielig und erschwert ausserdem noch das Isolationsproblem, da die Isolierung um so einfacher ist, je kleiner und leichter die Aktivteile gestaltet sind. Der Fehler der Sekundärspannung wird gemäss dem Stand der Technik auch durch schaltungstechnische Massnahmen unter Verwendung verschiedenster Elemente mehr oder weniger kompensiert.

Bekannt ist aus US-A-3 497 793 eine Einrichtung der eingangs genannten Art, bei welcher im Sekundärstromkreis des Spannungswandlers eine seiner Kurzschlussimpedanz nachgebildete Impedanz $Z_1$ angeordnet ist, die in Serie mit einer Kopplungsimpedanz $Z_2$ im Eingangskreis eines Verstärkers liegt, und die Kopplungsimpedanz $Z_2$ in Reihe mit einer ähnlichen Impedanz $Z_1$ im Ausgangskreis des Verstärkers liegt. Der Verstärker liefert an einem Ausgang eine elektromotorische Kraft, die für den Ausgleich des Spannungsabfalles an $Z_1$ und gleichzeitig auch zum Ausgleich des inneren Spannungsabfalles im Spannungswandler erforderlich ist, so dass die von der Primärspannung herrührende Ausgangsspannung an der Belastungsimpedanz $Z_u$ praktisch keinen Fehler aufweist. Diese bekannte Einrichtung arbeitet mit einem Differenz-Messverfahren, welches mit den entsprechenden Unsicherheiten infolge seiner Empfindlichkeit behaftet ist. Die Impedanz des Messkreises wird bei diesem Verfahren sehr vergrössert, so dass bei Verstärkerausfall der Fehler des Wandlers so stark ansteigt, dass eine technisch brauchbare Messgenauigkeit nicht mehr gegeben ist.

Ferner ist es aus DE-C-1 220 036 bekannt, die Bürdenabhängigkeit eines Spannungwandlers durch eine Kompensationsschaltung zu vermindern. Dabei wird eine bürdenabhängige Spannung auf den Primärkreis zurückgekoppelt und dadurch eine Verminderung des Fehlers erreicht. Weil die von der Spannung und dem Bürdenstrom hervorgerufenen Durchflutungen mit einer Ausnahme, verschobene Vektorrichtungen besitzen, ist die vorgesehene Kompensation dieser Durchflutungen schwer realisierbar. Gleichfalls liegen die induzierten Kompensationsspannungen in einer ungünstigen Vektorrichtung.

Aus DE-C-1 046 181 sind automatische Vorrichtungen zum Verringern des Fehlers von Spannungswandlern bekannt, bei denen eine in den Sekundärstromkreis in Funktion des Laststromes vormagnetisierte Drossel eingeschaltet ist. Die Eliminierung des lastabhängigen Uebertragungsfehlers erfolgt durch Bildung einer vom Laststrom abhängigen Grösse, welche mit einem Uebertrager aus dem Sekundärkreis gewonnen wird und der Einstellung des Arbeitspunktes der Drosselspule dient. Durch die Gewinnung der Kompensationsgrösse über die Steuerung des Arbeitspunktes auf der Magnetisierungslinie der Drosselspule ergibt sich auch eine Abhängigkeit des Kompensationseffektes von der Vektorlage des Belastungsstromes und eine Verzerrung der Kompensationsspannung.

Weiter ist eine Vorrichtung bekannt, die zwei primärseitig angeschlossene Spannungswandler verwendet. Die Sekundärspannung eines Wandlers ist an die Eingangsklemmen eines Verstärkers gelegt, dessen Ausgang an die Sekundärklemmen des andern Messwandlers angeschaltet ist. Der eine Messwandler dient der Bildung einer Leerlaufspannung, mit der die Sekundärspannung des belasteten Messwandlers verglichen wird, um ein Differenzsignal zu erhalten, das nach Betrag und Phase dem aufgetretenen Fehler entspricht und zu dessen Kompensation verwendet wird. Bei dieser Messvorrichtung ist es nicht möglich, einen der Messwandler tatsächlich im Leerlauf zu betreiben, so dass die praktische Verwirklichung des erwähnten Prinzips nicht den gewünschten Erfolg bringt. Darüber hinaus ist diese Anordnung für Hochspannungswandler sehr aufwendig.

Es sind aus dem Bulletin SEV 71 (1980) Seiten 450-455 und DE-B-2 508 061 Einrichtungen bekannt, die schwache Leistungen von Spannungswandlern auf das gewünschte Mass verstärken. Die gesamte Leistung ist praktisch vom Verstärker aufzubringen, der Wandler dient nur als Steuerelement. An solche Verstärker sind hohe Ansprüche hinsichtlich Stabilität in Abhängigkeit von Zeit und Temperatur, des Verstärkungsfaktors und des Winkelfehlers zwischen Eingangs- und Ausgangsspannung gestellt. Diese Grössen müssen für die verstärkte Leistung innerhalb des Toleranzbereiches der gewünschten Genauigkeitsklasse liegen.

In der DE-B-1 061 433 wird eine Wandlerprüfeinrichtung nach dem Differenzverfahren beschrieben. Die Kompensation des Fehlers erfolgt über sich an Widerständen ergebende Spannungsabfälle. In der Fig. 4 dieser Patentschrift ist ein Uebertrager 22 eingezeichnet, dem eine Impedanz 14 parallelgeschaltet ist. Dieser Uebertrager koppelt Primär- und Sekundärkreis und liegt nicht am Ein- oder Ausgang eines Verstärkers. Der in dieser Publikation beschriebene Kompensationskreis ist von dem beim Anmeldungsgegenstand eingesetzten völlig verschieden.

Beim Hochspannungswandler der eingangs genannten Art wird der Fehler erfindungsgemäss dadurch kompensiert, dass der vom Sekundärstrom erzeugte Spannungsabfall über einen Uebertrager am Eingang des Verstärkers liegt, dass die Ausgangsspannung über einen weiteren Uebertrager in den Sekundärkreis eingeschleift ist und dass den Uebertragern jeweils eine derartig dimensionierte Impedanz parallelgeschaltet ist, dass die jeweilige Parallelschaltung bei Verstärkerausfall und daraus resultierendem geringen Sekundärstrom eine geringe Impedanz darstellt.

Weiterbildungen der Erfindung sind in den Ansprüchen 2 bis 6 angegeben.

Grundsätzlich muss ein Spannungswandler seine Messgenauigkeit innerhalb eines gewissen Arbeitsbereiches erfüllen. Z. B. bei einpoligen Wandlern innerhalb des 0,8-1,2-fachen der Phasenspannung (minimale und maximale Messspannung). Demgegenüber ist der Wandler im Betrieb selbst einem weit grösseren Arbeitsbereich unterworfen. Beim oben erwähnten Wandler, z. B. einem Arbeitsbereich bis zum 1,9-fachen Wert der Phasenspannung. Die maximale Betriebsspannung bestimmt zusammen mit der Nennbürde des Wandlers die erforderliche Belastbarkeit des Verstärkers. Legt man den am Verstärkereingang liegenden Uebertrager so aus, dass die Sättigungsspannung im Eisenkern etwas oberhalb der Belastung mit dem der maximalen Messspannung entsprechenden Strom bei Nennbürde erreicht wird, dann steigt die Spannung am Verstärker bei Strömen und Spannungen über der maximalen Messspannung nur mehr schwach an. Der Verstärker braucht nur für eine Belastbarkeit ausgelegt zu werden, welche etwas über dem der maximalen Messspannung bei Nennbürde entsprechenden Wert liegt. Dadurch ergibt sich eine beträchtliche Einsparung am Verstärker. Diese Ersparnis soll die folgende Rechnung deutlich machen:

Einpoliger Wandler für Nennleistung 60 VA
Messspannung von 0.8-1,2 $U_n$
Betrieb von 0,22-1,9 $U_n$
($U_n$ = Phasenspannung)

Weist der Wandler bei Nennbetrieb einen Fehler von z. B. 6 % auf, dann ist, um eine Klasse 0,5 zu halten, eine Kompensationsleistung von etwa 5 % erforderlich, entsprechend 4 VA. Ohne die oben beschriebene Spezialanpassung des Uebertragers auf der Eingangsseite müsste die maximale Verstärkerbelastung $1,9^2 \cdot 3 = 11$ VA betragen.

Die Verwendung von Uebertragern mit parallelgeschalteten Impedanzen auf der Eingangs- und Ausgangsseite des Verstärkers erlaubt die Messung auch bei defektem Verstärker, mit reduzierter Genauigkeit. Bei Verstärkerausfall ergeben die entsprechend dimensionierten Impedanzen eine ausreichende Reduzierung der Uebertragerimpedanz. Der Fehler bleibt dann in technisch noch tragbaren Grenzen. Dies ist bei allen bekanntgewordenen Fehlerausgleichssystemen nicht möglich.·

Durch die den Uebertragerwicklungen parallelgeschalteten Impedanzen kann die Vektorlage der von den Transformatoren übertragenen Kompensationsspannung reguliert werden. Die vektorielle Verschiebbarkeit der Kompensationsspannung ermöglicht es, die Kompensation über den Verstärker allein durchzuführen. Praktischer ist es aber, die vom Verstärker gelieferte Kompensationsspannung mit einer Kompensationsspannung zu kombinieren, welche über einen in Serie geschalteten Kondensator erhalten wird. Dadurch ist die Lage des Spannungsvektors der von dem Verstärker gelieferten Kompensationsspannung in einem weiten Rahmen beliebig, weil diese Spannung mit einer gegen sie stark verschobenen Kompensationsspannung kombiniert wird. An das winkelgetreue Uebertragungsvermögen des Verstärkers werden somit nur geringe Anforderungen gestellt, und gleiche Toleranzen gelten auch für die Vektorlage der dem Verstärkereingang zugeführten Spannung.

Der erwähnte Kondensator kann direkt oder über einen Uebertrager in Serieschaltung in dem Sekundärkreis des Wandlers liegen. Das neue Kompensationsprinzip ermöglich auch eine Teilkompensation des Fehlers, so dass ein Restfehler in gewünschter Grösse und Richtung bestehen bleibt.

Die für den Verstärker erforderliche Fremdleistung kann einer Sekundärwicklung des Wandlers entnommen werden. Das entspricht einer zusätzlichen Belastung des Wandlers durch eine Festbürde. Der entsprechende Fehler kann in der oben beschriebenen Weise mit dem Fehler des Wandlers wegkompensiert werden.

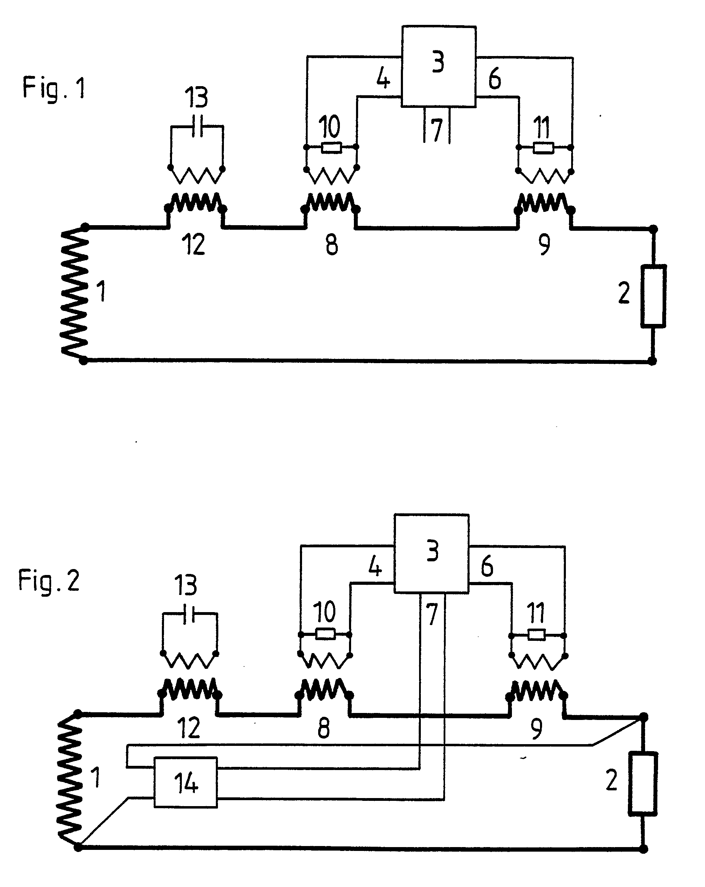

Die Figur 1 zeigt eine Anordnung des erfindungsgemässen fehlerkompensierten Wandlers. Mit (1) ist die Sekundärwicklung des Wandlers, welche die Bürde (2) speist, bezeichnet. Der Verstärker (3) wird eingangsseitig (4) vom Spannungsabfall an der einem Uebertrager (8) parallelgeschalteten Impedanz (10) gesteuert. Die am Verstärkerausgang (6) gelieferte Spannung ist mit einem Uebertrager (9), der eine Parallelimpedanz (11) besitzt, in den Sekundärkreis des Wandlers eingeschleift. Am Transformator (12) ist ein Kondensator (13) angeschlossen, welcher eine zusätzliche Kompensationsspannung liefert. Mit (7) ist der Fremdspannungsanschluss des Verstärkers bezeichnet.

In Figur 2 erfolgt die Spannungsversorgung des Verstärkers über einen Spannungskonstanthalter (14) von der Wandlerwicklung selbst.

**Patentansprüche**

1. Hochspannungswandler, bei welchem der durch die Bürde (2) bedingte Fehler mittels eines Verstärkers (3) im Sekundärstromkreis kompensiert wird, bei welchem ein in seiner Vektorrichtung durch eine Abgriffimpedanz bestimmter, vom Sekundärstrom erzeugter kleiner Spannungsabfall am Eingang (4) des Verstärkers (3) liegt und bei welchem die Ausgangsspannung (6) dieses Verstärkers (3) in Serie in den Sekundärkreis des Wandlers (1) eingeschleift ist, dadurch gekennzeichnet, dass der vom Sekundärstrom erzeugte Spannungsabfall über einen Uebertrager (8) am Eingang des Verstärkers (3) liegt, dass die Ausgangsspannung (6) über einen weiteren Uebertrager (9) in den Sekundärkreis eingeschleift ist und dass den Uebertragern (8, 9) jeweils eine derartig dimensionierte Impedanz (10, 11) parallelgeschaltet ist, dass die jeweilige Parallelschaltung (8, 10 ; 9, 11) bei Verstärkerausfall und daraus resultierendem geringen Sekundärstrom eine geringe Impedanz darstellt.

2. Hochspannungswandler nach Anspruch 1, dadurch gekennzeichnet, dass der Eisenkern des Uebertragers (8) am Eingang des Verstärkers (3) oberhalb des Arbeitsbereiches des Wandlers, innerhalb welchem die Genauigkeit garantiert werden muss, in die magnetische Sättigung eintritt.

3. Hochspannungswandler nach Anspruch 1, dadurch gekennzeichnet, dass zusätzlich zu der über den Verstärker (3) erhaltenen Kompensationsspannung eine über einen Kondensator (13) gebildete Kompensationsspannung verwendet wird, wobei der Kondensator in Serieschaltung im Sekundärkreis des Wandlers liegt.

4. Hochspannungswandler nach Anspruch 2, dadurch gekennzeichnet, dass der Kondensator mittels eines Uebertragers (12) in Serieschaltung im Sekundärkreis des Wandlers liegt.

5. Hochspannungswandler nach einem der Ansprüche 1 bis 3, dadurch gekennzeichnet, dass die der Sekundärwicklung des auf der Eingangsseite des Verstärkers (3) liegenden Uebertragers (8) parallelgeschaltete Impedanz (10) so beschaffen ist, dass die an ihr abgegriffene Eingangsspannung für den Verstärker (3) die gewünschte Grösse und Vektorlage besitzt.

6. Hochspannungswandler nach einem der Ansprüche 1 bis 4, dadurch gekennzeichnet, dass die Spannungsversorgung des Verstärkers (3) über die Wandlerwicklung (1) unter Zwischenschaltung eines Spannungsstabilisators (14) erfolgt und daß der durch diese Festbürde hervorgerufene Fehler ebenfalls eliminiert wird.

## Claims

1. High voltage instrument transformer, in which the error caused through the burden (2) is compensated through the amplifier (3) placed in the secondary circuit, in which a small voltage drop created by the secondary current in amplitude and vectorial direction across a tapped impedance is applied at the entrance (4) of the amplifier (3), at which the output voltage (6) of the amplifier (3) is inserted in serie into the secondary circuit of the transformer (1), characterized through the fact that the voltage drop caused by the secondary current is connected through a translator (8) placed at the entrance of the amplifier (3) and that the output voltage (6) is reinserted into the secondary circuit through a further translator (9) and that an impedance (10, 11) is connected parallely to both translators (8, 9), the value of this impedance being designed in order to keep the impedance of the complete parallel circuit (8, 10 ; 9, 11) to a minimum in case of failure of the amplifier and resulting decrease of the secondary current.

2. High voltage instrument transformer according to claim 1, characterized through the fact that the iron core of the translator (8) connected at the entrance of the amplifier (3) reaches the magnetic saturation above the voltage range inside of which the precision class of the transformer is guaranteed.

3. The high voltage instrument transformer according to claim 1, characterized through the fact that, in addition to the compensatory voltage obtained through the amplifier (3), an other compensation gained through a condenser (13), is available over a condenser connected in serie in the secondary circuit of the transformer.

4. High voltage instrument transformer according to claim 2, characterized through the fact, that the condenser is situated in serie with the secondary circuit of the transformer over a translator.

5. High voltage instrument transformer according to one of the claims 1 to 3, characterized through the fact, that the impedance (10) connected parallelly to the secondary winding of the translator (8) situated on the input side of the amplifier (3) is designed on such a way, that the input voltage for the amplifier tapped on that impedance has the required amplitude and vectorial direction.

6. High voltage instrument transformer according to one of the claims 1 to 4, characterized through the fact, that the supply voltage of the amplifier (3) occurs over the transformer's and that the voltage drop due to this constant burden is eliminated as well.

## Revendications

1. Transformateur de mesure pour haute-tension, dans lequel l'erreur causée par la charge (2) est compensée au moyen d'un amplificateur (3) dans le circuit secondaire, dans lequel la chute de tension créée par le courant secondaire en grandeur et en direction vectorielle à travers une impédance de dérivation est appliquée à l'entrée (4) de l'amplificateur (3) et dans lequel la tension de sortie (6) de cet amplificateur (3) est insérée en série dans le circuit secondaire, est caractérisé par le fait que la chute de tension créée par le courant secondaire est appliquée par l'intermédiaire d'un translateur (8) à l'entrée de l'amplificateur (3) et par le fait que la tension de sortie (6) est insérée dans le circuit secondaire par un autre translateur (9) et que l'impédance (10, 11) est branchée en parallèle sur chaque translateur (8, 9), la valeur de celle-ci étant dimensionnée de façon à ce que, en cas de panne ou de non-fonctionnement de l'amplificateur, et de chute résultante du courant secondaire, l'impédance du circuit parallèle (8, 10 ; 9, 11) reste minime.

2. Transformateur de mesure pour haute-tension selon demande no 1, caractérisé par le fait que le noyau fer du translateur (8) placé à l'entrée de l'amplificateur (3), entre en saturation magnétique au-dessus de la gamme de tension définie par l'exactitude garantie du transformateur.

3. Transformateur de mesure pour haute-tension répondant aux caractéristiques de la demande no 1 pouvant disposer, en plus de la tension de compensation obtenue par l'amplificateur (3), d'une tension de compensation supplémentaire produite par le condensateur (13) placé en série sur le circuit secondaire du transformateur.

4. Transformateur de mesure pour haute-tension répondant aux caractéristiques no 2, où le condensateur (13) est branché en série dans le circuit secondaire de l'appareil à travers un translateur (12).

5. Transformateur de mesure pour haute-tension selon une des demandes 1 à 3 ; l'impédance (10) branchée en parallèle sur l'enroulement secondaire du translateur (8) placé du côté de l'entrée de l'amplificateur (3) est conçue de telle manière que la tension obtenue à l'entrée de celui-ci possède grandeur et direction vectorielle requises.

6. Transformateur de mesure pour haute-tension selon une des demandes 1 à 4 ; caractérisé par le fait que la tension d'alimentation de l'amplificateur (3) est fournie en insérant sur l'enroulement (1) de l'appareil de transformation un stabilisateur de tension (14) et par le fait que la chute de tension provoquée par cette charge est également éliminée.

Fig. 1

Fig. 2